# EUROPEAN PATENT APPLICATION

(11) **EP 3 484 041 A1**
(43) Date of publication of application: **15.05.2019**
(21) Application number: 17201089.4
(22) Date of filing: 10.11.2017
(51) Int. Cl.: H02M 7/5387, H02M 7/5395, H02P 29/68, H02P 21/04, H02P 3/02, H05K 7/20, H02M 1/32

(54) **INVERTER FOR AN ELECTRIC MACHINE, ELECTRIC MACHINE FOR A VEHICLE, VEHICLE, METHOD FOR OPERATING AN INVERTER AND METHOD FOR DETERMINING A SET OF PREDEFINED SPACE VECTOR ANGLES**

(71) Applicant: Valeo Siemens eAutomotive Germany GmbH, 91056 Erlangen (DE)
(72) Inventor: BOHLLÄNDER, Marco, 96114 Hirschaid (DE)
(74) Representative: Dr. Gassner & Partner mbB

(57) **Abstract**

Inverter (5) for an electric machine (1), comprising at least three output phases (11a to 11c) and a plurality of switching modules (8a to 8c) configured to provide a switched voltage to the output phases (11a to 11c), wherein the inverter comprises a controller (9) configured to control the switching modules (8a to 8c) to provide the switched voltages such that in a zero-rotation mode currents having a predefined space vector angle are supplied to the output phases (11a to 11c).

## Description

The present invention relates to an inverter for an electric machine, comprising at least three output phases and a plurality of switching modules configured to provide a switched voltage to the output phases. Aside, the invention relates to an electric machine for a vehicle, a vehicle, a method for operating an inverter and a method for determining a set of predefined space vector angles.

Inverters are widely used to convert a DC input into a multiphase AC output. With respect to automotive applications, output phases of the inverter are typically connected to stator windings of an electric machine. The inverter comprises one or more switching modules for each output phase providing a switched, typically pulse width modulated, voltage to the output phase. The voltages cause AC currents to flow through the stator windings. The currents have a fixed phase offset corresponding to a specific position of a rotor of the electric machine. In the case of a zero-rotation mode of the electric machine, such as a standstill event of a vehicle, each stator winding conducts a substantially stationary current. This current corresponds to a space vector angle, in which the zero-rotation mode has been adopted, and thus to a fixed duty cycle of a respective switched voltage.

However, as the zero-rotation mode may be adopted at an arbitrary space vector angle, electric loads of the switching modules may be highly non-uniform at certain disadvantageous space vector angles. The non-uniform loads may cause the switching modules to heat up differently depending on the adopted space vector angle. Conventional inverters derate the total current flow into the stator windings if a junction temperature of the warmest switching module reaches a certain threshold value. With other words, the length of the space vector is reduced at a fixed angle for protecting the warmest switching module from overheating.

Consequently, a holding torque applied to a rotor in the zero-rotation mode is reduced, undesirably.

Thus, it is an object of the present invention to provide an inverter with improved operational characteristics in a zero-rotation mode.

This object is achieved by an inverter as initially described, comprising a controller configured to control the switching modules to provide the switched voltages such that in a zero-rotation mode currents having a predefined space vector angle are supplied to the output phases.

The invention is based upon the consideration to adopt a distinguished, predefined space vector angle in the zero-rotation mode of the inverter. Thus, it is suggested not to adopt a space vector angle, which is present arbitrarily when the controller is triggered to transfer into the zero-rotation mode, but to adopt the predefined space vector angle.

Advantageously, a highly non-uniform thermal load of the switching modules caused by an inconvenient space vector angle adopted in the zero-rotation mode is avoided. The inverter according to the invention is operated at lower junction temperatures of the switching modules. Thus, an early reduction of the current supplied to stator windings of the electric machine resulting in an early reduction of a holding torque provided in the zero-rotation mode is avoided.

The space vector angle may be identified with a specific phase position of the currents being substantially sinusoidal and having a fixed phase offset to adjacent output phases. Preferably, at the predefined space vector angle the currents are held of a substantially constant level at least for a specific time span. With other words, at the predefined space vector angle the absolute value or the length of the space vector is kept substantially constant at least for the time span.

Typically, each switching module comprises two switching elements interconnected to a half bridge. The half bridge may be connected to a DC link of the inverter. Each switching element may comprise a first semiconductor structure, which is particularly a transistor structure, such as an insulated gate bipolar transistor (IGBT) structure, an insulated gate field-effect transistor structure, preferably a metal oxide semiconductor field-effect transistor (MOSFET) structure, or a junction field-effect transistor (JFET) structure. Alternatively, the first semiconductor structure maybe a thyristor structure, such as a gate turn-off (GTO) thyristor structure. Each switching element may comprise a second semiconductor structure, which may be a diode, particularly working as a freewheeling diode. The second semiconductor structure may be connected in parallel to the second semiconductor structure. Preferably, the switching elements of each switching module form a single and/or monolithic unit. According to further embodiments of the invention, the switching modules may be switching elements or semiconductor structures as described before. The controller may be configured to control the switching modules to provide a rotating space vector angle in a driving mode, from which the inverter is transferred into the zero-rotation mode. Preferably, transferring the inverter into the zero-rotation mode it is triggered by an external signal, e.g. obtained from a vehicle control unit.

According to a preferred embodiment of the invention, the first switching module has a lower thermal resistance than second switching modules, wherein at the predefined space vector angle the first switching element consumes a higher electric power than the second switching modules. It has been found out that the thermal resistance of the first switching module may be lower than the thermal resistance of the other switching modules caused by various mounting parameters. Having identified such a first switching module, it is suggested to predefine possible space vector angles such that the first switching module is loaded electrically higher than the second switching modules. As the first switching module is capable of a higher heat dissipation to its environment, a distinguished non-uniform electric load of the switching modules is provided in order to reach a substantially uniform thermal load among the switching modules.

Particularly, the inverter comprises a cooling channel configured to conduct a coolant thermally coupled to the switching modules, wherein the first switching module is arranged before the second switching modules with respect to a flow direction of the coolant. The thermal resistance between the first switching module and the cooling channel may be lower than the thermal resistance between the second switching modules and the cooling channel due to a mounting position, in which the coolant cools the second switching modules after having cooled the first switching module. Typically, the switching modules are arranged on a carrier element. The carrier element may be thermally connected to the cooling channel. The carrier element may comprise a cooling structure reaching into the coolant substantially perpendicular to the flow direction, such as pin fins. The cooling channel may be drilled or milled into a cooling block or formed by casting a cooling block. Particularly, the carrier element is arranged on and thermally coupled with the cooling block.

Preferably, the first switching module is arranged behind a redirection structure of the cooling channel with respect to the flow direction. It has been recognized by experiments, that the first switching module arranged behind a redirection structure of the cooling channel has a significantly lower thermal resistance than a second switching module not being arranged behind a redirection structure. This is assumed to be caused by turbulences disrupting a laminar flow of the coolant. Thus, it is advantageous to choose the switching module behind the redirection structure to be the first switching module. Particularly, no second switching module is arranged between the redirection structure and the first switching module. Note that the above-mentioned turbulences do not refer to microscopic turbulences generated by the cooling structure, but to macroscopic turbulences generated by the redirection structure. Alternatively or additionally, between the first switching module and an adjacent second switching module the cooling channel extends with a lower curvature than the curvature of the redirection structure.

Between the first switching module and an adjacent second switching module the cooling channel may extend rectilinearly. It has been found out experimentally that a distinctive distribution of thermal resistances allowing the predefinition of the space vector angles is achieved by this geometry of the cooling channel.

Furthermore, the inverter may comprise a smoothing capacitor thermally coupled to the cooling channel and being arranged before or behind the first switching module with respect to the flow direction. This allows a very compact realization of the inverter since only one cooling channel is necessary for a common cooling of the switching modules and the smoothing capacitor. Preferably, the redirection element is arranged between the first switching module and the smoothing capacitor with respect to the flow direction of the coolant.

Particularly with respect to arrangements of the switching modules having a substantially uniform distribution of the thermal resistances at the predefined space vector angle the absolute value of a current of each output phase may not have a maximum magnitude. Therein, the maximum magnitude refers to the highest amplitude of the sinusoidal currents.

Alternatively or additionally, the controller may be configured to choose a space vector angle from a set of predefined space vector angles as the predefined space vector angle. The set may be stored in an internal memory of the controller. The set may be determined experimentally, wherein in a stationary thermal state of the inverter junction temperature functions ϑᵢ(ϕ) of a space vector angle ϕ are determined over a full rotation period, i.e. over space vector angles ϕ between 0° and 360°, for each switching module, each switching element or each semiconductor structure. Then, a combined function ϑ_{c}(ϕ) may be determined, comprising for each space vector angle ϕ the temperature value of the function ϑᵢ(ϕ) having the highest temperature. Expressed mathematically, ϑ_{c}(ϕ) = max{ ϑᵢ(ϕ)} for each space vector angle. Thus, the progress of the function ϑ_{c}(ϕ) may be considered as an envelope curve. The set is chosen such that it comprises a number of values being minimum values of ϑ_{c}(ϕ). Alternatively, the number of values may comprise values within an interval between two adjacent minimum values, wherein further minimum values of ϑ_{c}(ϕ) being adjacent to the interval are greater than the minimum values limiting the interval. The stationary state is typically a state, in which thermal capacitances of the inverter are substantially loaded.

Preferably, the controller is configured to control the switching modules in the zero-rotation mode such that a torque unequal to zero is provided.

Advantageously, a vehicle comprising the inverter according to the invention may be held in standstill when standing uphill or downhill. This is particularly suitable for automotive applications such as a hill start assist system.

Aside, the invention relates to an electric machine, comprising an inverter according to the invention and a plurality of stator windings supplied by the output phases of the inverter.

Furthermore, the invention relates to a vehicle, comprising an electric machine according to the invention configured to drive the vehicle.

Additionally, the invention relates to a method for operating an inverter for an electric machine, comprising at least three output phases, wherein a plurality of switching modules provides a switched voltage to the output phase, wherein the switching modules provide the voltages such that currents having a predefined space vector angle in a zero-rotation mode are supplied to the output phases.

Finally, the invention relates to a method for determining a set of predefined space vector angles for an inverter according to the invention, comprising the steps: In a stationary thermal state of the inverter, determining junction temperature functions of a space vector angle over a full rotation period for each switching module, each switching element or each semiconductor structure; Determining a combined function, comprising for each space vector angle the temperature value of the function having the highest temperature; and choosing the set of space vector angles such that it comprises a number of minimum values of the combined function or that it comprises values inside an interval between two adjacent minimum values, wherein futher minimum values of the combined function being adjacent to the interval are greater than the minimum values limiting the interval.

All statements referring to the inventive inverter apply analogously to the inventive electric machine, the inventive vehicle and the inventive methods, so that the above-mentioned advantages of the inventive inverter may be achieved as well.

Further details and advantages of the invention are disclosed in the following, wherein reference is made to the schematic drawings showing:
- Fig. 1: a block diagram of a first embodiment of an electric machine according to the invention;
- Fig. 2: a diagram of a three-phase current over time and temperature functions over a space vector angle referring to the embodiment depicted in Fig. 1;
- Fig. 3: a schematic diagram of switching modules and a cooling channel of an electric machine according to a second embodiment of the invention;
- Fig. 4: a diagram of temperature functions over a space vector angle referring to the embodiment depicted in Fig. 3; and
- Fig. 5: a schematic diagram of an embodiment of a vehicle according to the invention.

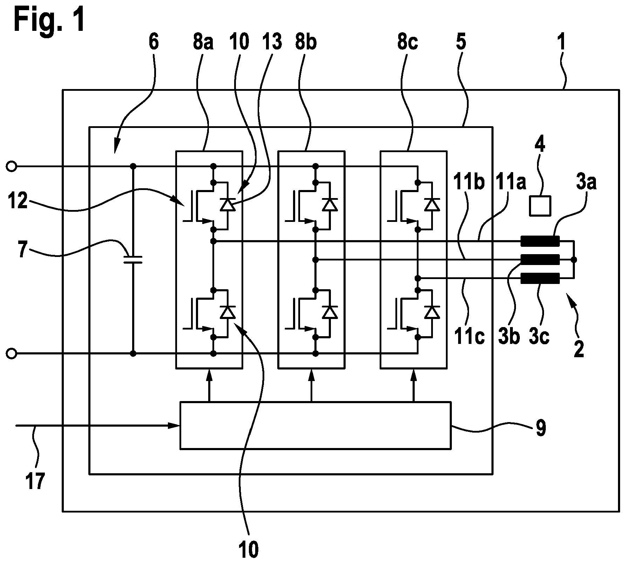

Fig. 1 is a block diagram of a first embodiment of an electric machine 1, comprising a stator 2 with the stator windings 3a to 3c. Moreover, the electric machine has a rotor 4 and an inverter 5.

The inverter 5 comprises a DC link 6 with a smoothing capacitor 7. Furthermore, the inverter 5 has three switching modules 8a to 8c and a controller 9. Each switching module 8a to 8c comprises two switching elements 10 interconnected to a half bridge, wherein a central tap between the switching elements 10 is connected to one stator winding 3a to 3c via a corresponding output phase 11a to 11c. Each switching element 10 comprises a first semiconductor structure being a transistor structure 12, such as an insulated gate bipolar transistor (IGBT) structure, an insulated gate field-effect transistor structure, particularly a metal oxide semiconductor field-effect transistor (MOSFET) structure, or a junction field-effect transistor structure (JFET). Additionally, each switching element 10 comprises a second semiconductor structure being a diode 13. The diode 13 is connected in parallel to the transistor structure 12 being formed as a freewheeling diode. With respect to the transistor structure 12 being an insulated gate field-effect transistor the diode 13 may be the body diode.

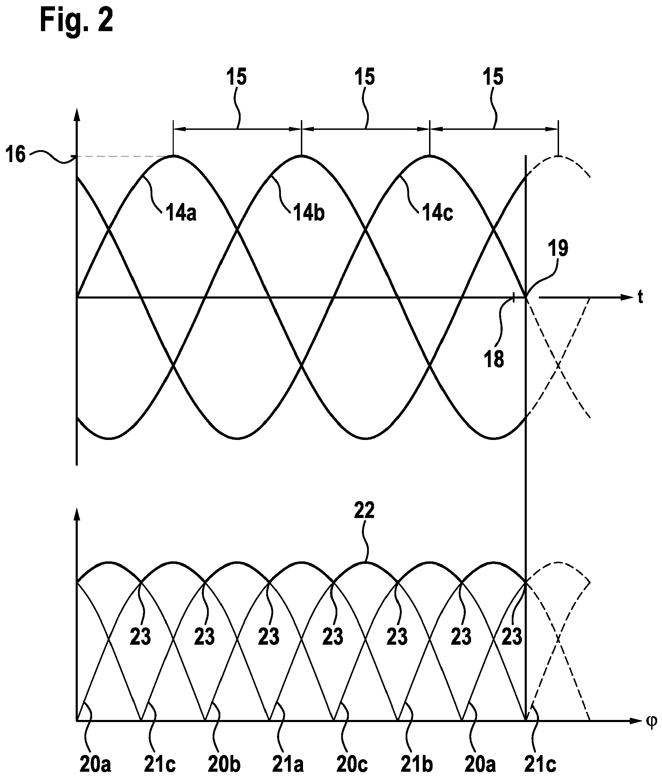

In a normal driving mode of the inverter 5 the controller 9 is configured to control the switching modules 8a to 8c to provide a switched, particularly pulse width modulated, voltage to the output phases 11 a to 11 c resulting in corresponding sinusoidal currents 14a to 14c as being depicted in Fig. 2 over time. The currents 14a to 14c have a phase offset 15 to adjacent phases, here 120° in the case of a three-phase AC current. Thus, a phase position of the currents 14a to 14c at a specific time corresponds to a space vector angle with an absolute value corresponding to the maximum magnitude 16 of a respective current 14a to 14c. The currents 14a to 14c flowing through the stator windings 3a to 3c cause the rotor 4 to rotate with a certain rotation rate higher than zero.

At a time 18 the controller 9 receives an external signal 17, e.g. obtained by a vehicle control unit. The external signal 17 triggers the controller 9 to transfer the inverter 5 from the driving mode into a zero-rotation mode, in which the rotation rate is zero and a holding torque is applied to the rotor 4. Within an internal memory of the controller 9 a predefined number of space vector angles to be adopted in the zero-rotation mode is stored, such as the space vector angle corresponding to the phase position at a time 19. The space vector angles are predefined such that a thermal load of the switching modules 8a to 8c issubstantially optimal. Particularly, space vector angles, at which one of the currents has its maximum magnitude considered to be not suitable.

Fig. 2 depicts simplified junction temperature functions ϑᵢ(ϕ) denoted by reference signs 20a to 20c, 21 a to 21 c over a space vector angle ϕ for the transistor structures 12, wherein the functions 20a to 20c refer to the top transistor structures 12 of the switching modules 8a to 8c and the functions 21 a to 21 c refer to the bottom transistor structures 12 of the switching modules 8a to 8c. When a top transistor structures 12 heats up, the bottom diode 13 of the same switching module 8a to 8c heats up as well and vice versa as a corresponding current is split up. It is assumed that the transistor structures 12 heat up higher than the diodes 13, which may be different with respect to specific hardware designs. Furthermore, for reasons of simplicity the junction temperature progresses of a transistor structure 12 and the diode 13 of the same switching element 10 are assumed to be decoupled, which may be different again with respect to the specific hardware designs. Thus, functions of the junction temperature of the diodes 13 are not depicted in Fig. 2.

According to a method for determining the set of predefined space vector angles the junction temperature functions 20a to 20c, 21 a to 21 c are determined. Afterwards, a combined function ϑ_{c}(ϕ) denoted by reference sign 22 is determined, comprising for each space vector angle ϕ the temperature value of the function ϑᵢ(ϕ) having the highest temperature at a space vector angle. Expressed mathematically, ϑ_{c}(ϕ) = max{ϑᵢ(ϕ)} for each space vector angle ϕ. The combined function 22 may be considered as an envelope curve. The set of space vector angles is chosen such that it comprises the minimum values 23 of the function 22.

Upon receiving the external signal 17 at the time 18 the controller 9 chooses a space vector angle out of the set of space vector angles and controls the switching modules 8a to 8c to rotate a short time longer or to rotate backwards until the chosen predefined space vector angle is adopted at time 19. At the time 19 the controller 9 controls the switching modules 8a to 8c to provide the switched voltages with a fixed duty cycle to the output phases 11 a to 11 c and the stator windings 3a to 3c. This results in a substantially constant progression of the currents 14a to 14c after the time 19, wherein dashed lines in Fig. 2 depict a hypothetical progression of the currents 14a to 14c if the driving mode had been kept.

At the adopted space vector angle after the time 19, the junction temperatures of the switching modules 8a to 8c have a nearly uniform distribution. This avoids the disadvantage of conventional inverters, in which the junction temperature of one switching module rises faster than the junction temperature of the other switching modules. This non-uniform thermal load causes the controller to reduce the currents such that the junction temperature of the warmest switching module does not exceed a certain threshold. In contrast, the warming of the switching modules of the inverter 5 is uniform resulting in that a reduction of the currents 14a to 14c is avoided or postponed as long as possible.

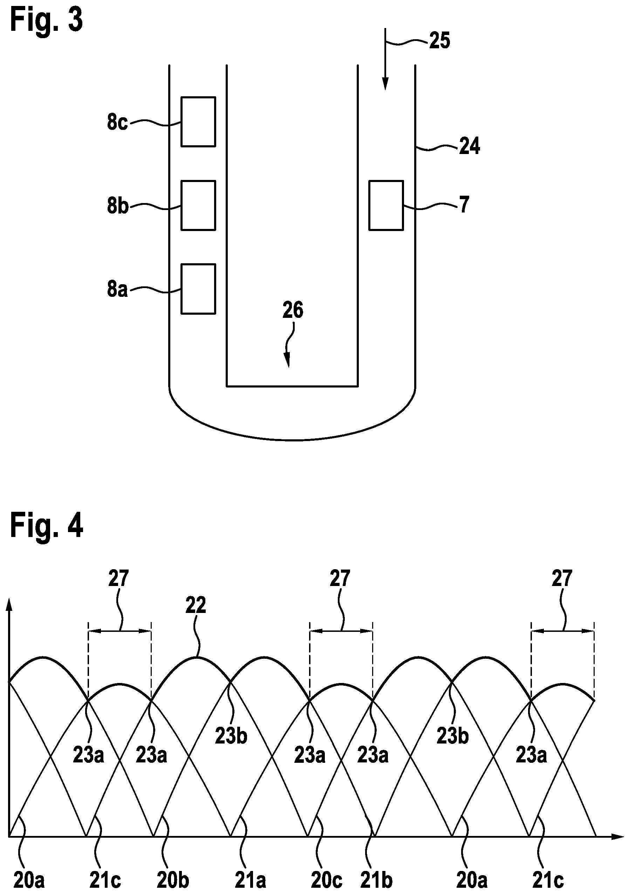

Fig. 3 is a schematic diagram of switching modules and a cooling channel of an electric machine 1 according to a second embodiment corresponding to the one depicted in Fig. 1, wherein a cooling channel 24 conducting a coolant with a flow direction 25 (represented by an arrow) and cooling the smoothing capacitor 7 and the switching modules 8a to 8c is provided.

The smoothing capacitor 7 is arranged before the switching modules 8a to 8c with respect to the flow direction 25. Among the switching modules 8a to 8c, the first switching module 8a is arranged before the second switching modules 8b, 8c with respect to the flow direction 25. Between the smoothing capacitor 7 and the first switching module 8a the cooling channel 24 comprises a redirection structure 26 being formed by shaping or bending of the cooling channel 20 with a specific curvature. Behind the redirection structure 26 with respect to the flow direction 25 the cooling channel 24 extends substantially rectilinearly. Thus, the curvature of the cooling channel 24 behind the first switching module 8a is lower than the curvature of the redirection structure 26. Although not depicted in Fig. 3, the redirection 26 may comprise or be a separator element reaching into the cooling channel 24.

It has been found out experimentally, that the thermal resistance of the first switching module 8a is significantly lower than a respective thermal resistance of the second switching modules 8b, 8c due to turbulences of the coolant generated by the redirection structure 26. With respect to this non-uniform distribution of the thermal resistances, the space vector angles are predefined such that the electric power consumed by the first switching module 8a is higher than the electric power consumed by the second switching modules 8b, 8c in the zero-rotation mode. Although the electric load of the first switching module 8a is higher at the predefined space vector angle than the electric load of the second switching modules 8b, 8c, a substantially uniform warming of the switching modules 8a to 8c is achieved in the zero-rotation mode as the thermal resistance of the first switching module 8a is significantly lower than the thermal resistances of the second switching modules 8b, 8c.

The aforementioned turbulences do not result from cooling structures, such as pin fins, extending perpendicularly to the flow direction from the switching modules 8a to 8c into the cooling channel 24. Instead, the turbulences decreasing the thermal resistance of the first switching module 8a result from a laminar flow of the coolant being disrupted by the redirection structure 26.

Fig. 4 depicts simplified functions 20a to 20c, 21 a to 21 c of the transistor structures 12 over the space vector angle ϕ, corresponding to Fig. 2. As can be seen, the maxima of the functions 20a, 21 a are significantly lower than the maxima of the functions 20b, 20c, 21 b, 21 c due to the lower thermal resistance of the first switching module 8a. Thus, the set of space vector angles can be determined by a method as described with reference to Fig. 2, wherein space vector angles are chosen that are within intervals 27 between two adjacent minimum values 23a, wherein further minimum values 23b being adjacent to the interval 27 are greater than the minimum values 23b limiting the interval 27.

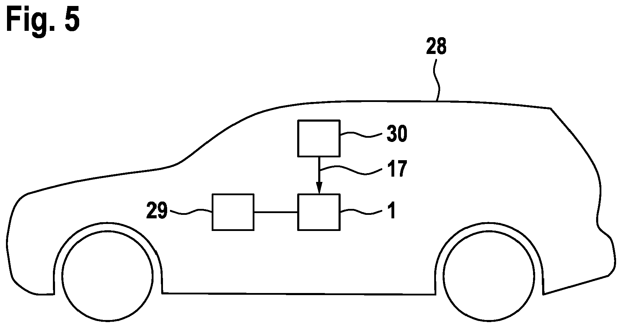

Fig. 5 is a schematic diagram of an embodiment of a vehicle 28 comprising an electric machine 1 according to one of the aforementioned embodiments for driving the vehicle 28 and a high-voltage battery 29 supplying a DC voltage to the DC link 6 of the inverter 5 of the electric machine 6. Additionally, the vehicle 28 comprises a vehicle control unit 30 configured to provide the external signal 17 to the controller 9 of the inverter 5. The vehicle control unit 30 realizes the function of a hill start assist system and triggers the controller 9 to transfer a inverter 5 to the zero-rotation mode in order to provide the holding torque.

## Claims

1. Inverter (5) for an electric machine (1), comprising at least three output phases and a plurality of switching modules (8a to 8c) configured to provide a switched voltage to the output phases (11 a to 11c), **characterized by** a controller 9 configured to control the switching modules (8a to 8c) to provide the switched voltages such that in a zero-rotation mode currents (11 a to 11c) having a predefined space vector angle are supplied to the output phases.

2. Inverter according to claim 1, **characterized in that** the first switching module (8a) has a lower thermal resistance than second switching modules (8b, 8c), wherein at the predefined space vector angle the first switching module (8a) consumes a higher electric power than the second switching modules (8a, 8b).

3. Inverter according to claim 2, **characterized in that** the inverter (5) comprises a cooling channel (24) configured to conduct a coolant thermally coupled to the switching modules (8a to 8c), wherein the first switching module (8a) is arranged before the second switching modules (8b to 8c) with respect to a flow direction (25) of the coolant.

4. Inverter according to claim 2 or 3, **characterized in that** the first switching (8a) module is arranged behind a redirection structure (26) of the cooling channel (24) with respect to the flow direction (25).

5. Inverter according to claim 4, **characterized in that** between the first switching (8a) module and an adjacent second switching module (8b) the cooling channel (24) extends with a lower curvature than the curvature of the redirection structure (26).

6. Inverter according to any of claims 3 to 5, **characterized in that** between the first switching module (8a) and an adjacent second switching module (8b) the cooling channel extends rectilinearly.

7. Inverter according to any of claims 3 to 6, **characterized in that** the inverter (5) comprises a smoothing capacitor (7) thermally coupled to the cooling channel (24) and being arranged before or behind the first switching module (8a) with respect to the flow direction (25).

8. Inverter according to any of the preceding claims, **characterized in that** at the predefined space vector angle the absolute value of a current of each output phase (11 a to 11 c) is neither zero nor has a maximum magnitude.

9. Inverter according to any of the preceding claim, **characterized in that**, the controller (9) is configured to choose a space vector angle out of a set of predefined space vector angles as the predefined space vector angle.

10. Inverter according to any of the preceding claims, **characterized in that** the controller (9) is configured to control the switching modules (8a to 8c) in the zero-rotation mode such that a torque unequal to zero is provided.

11. Electric machine (1), comprising an inverter (5) according to any of claims 1 to 10 and a plurality of stator windings (3a to 3c) supplied by the output phases (11 a to 11 c) of the inverter.

12. Vehicle (28), comprising an electric machine (1) according to claim 11 configured to drive the vehicle (28).

13. Method for operating an inverter (5) for an electric machine (1), comprising at least three output phases (11 a to 11 c), wherein a plurality of switching modules (8a to 8c) provide a switched voltage to the output phases (11 a to 11c), wherein the switching modules (8a to 8c) provide the voltages such that currents having a predefined space vector angle in a zero-rotation mode are supplied to the output phases.

14. Method for determining a set of predefined space vector angles for an inverter (5) according to claim 9, comprising the steps:
- In a stationary thermal state of the inverter (5), determining junction temperature functions (20a to 20c, 21 a to 21 c) of a space vector angle over a full rotation period for each switching module (8a to 8c), each switching element (10) or each semiconductor structure;
- Determining a combined function (22), comprising for each space vector angle the temperature value of the function (20a to 20c, 21 a to 21 c) having the highest temperature; and
- Choosing the set of space vector angles such that it comprises a number of minimum values (23) of the combined function (22) or that it comprises values inside an interval (27) between two adjacent minimum (23a) values, wherein further minimum values (23b) of the combined function (22) being adjacent to the interval (27) are greater than the minimum values (23a) limiting the interval (27).
